Europäisches Patentamt

European Patent Office

Office européen des brevets

(19)

(11) Numéro de publication: **0 385 961**
**A1**

(12)
# DEMANDE DE BREVET EUROPÉEN

(21) Numéro de dépôt: **90870007.3**

(22) Date de dépôt: **15.01.90**

(51) Int. Cl.5: **C25D 1/08**

(30) Priorité: **31.01.89 BE 8900093**

(43) Date de publication de la demande:
**05.09.90 Bulletin 90/36**

(84) Etats contractants désignés:
**AT BE CH DE ES FR GB IT LI NL SE**

(71) Demandeur: **CENTRE DE RECHERCHES METALLURGIQUES CENTRUM VOOR RESEARCH IN DE METALLURGIE Association sans but lucratif Vereniging zonder winstoogmerk Rue Montoyer, 47**
**B-1040 Bruxelles(BE)**

(72) Inventeur: **Crahay, Jean**
**Ster, 307**
**B-4878 Francorchamps(BE)**
Inventeur: **Economopoulos, Marios**
**Quai Marcellis, 6/111**
**B-4020 Liège(BE)**
Inventeur: **Lambert, Nicole**
**Avenue Guillaume Joachim, 42**
**B-4370 Waremme(BE)**

(74) Mandataire: **Lacasse, Lucien Emile**
**CENTRE DE RECHERCHES METALLURGIQUES Abbaye du Val-Benoît 11, rue Ernest Solvay**
**B-4000 Liège(BE)**

(54) **Dispositif de fabrication, par électrodéposition, d'une feuille métallique perforée de faible épaisseur, aiasi que procédés de réalisation et d'utilisation d'un tel dispositif.**

(57) Le dispositif comporte une cathode (3) électriquement conductrice ayant une surface active qui présente au moins un îlot non réceptif au dépôt. Cet îlot (4) est noyé dans la cathode et il présente une face extérieure située à fleur de la surface active de la cathode. Cet îlot peut être formé dans un creux ménagé soit dans la surface active de la cathode soit dans une couche conductrice déposée sur cette surface active. L'îlot peut être formé par dépôt localisé ou par dépôt continu et élimination sélective selon le motif désiré. On forme une couche de métal par électrodéposition sur la cathode ainsi préparée et on détache ensuite la feuille perforée (1).

Fig.3

# Dispositif de fabrication, par électrodéposition, d'une feuille métallique perforée de faible épaisseur, ainsi que procédés de réalisation et d'utilisation d'un tel dispositif.

La présente invention concerne un dispositif de fabrication, par électrodéposition, d'une feuille métallique perforée de faible épaisseur. Elle porte également sur des procédés de réalisation et d'utilisation d'un tel dispositif, ainsi que sur une feuille métallique perforée de faible épaisseur produite à l'aide de ce dispositif.

Au sens de la présente invention, l'expression "feuille métallique perforée de faible épaisseur" désigne une feuille métallique dont l'épaisseur est inférieure à 500 μm et qui présente des perforations de forme quelconque, régulière ou irrégulière, réparties de façon quelconque, régulière ou irrégulière. Ce type de feuille métallique est notamment utilisé pour la fabrication des accumulateurs au Ni-Cd, de circuits imprimés pour l'électronique, de filtres, d'éléments de renforcement de matériaux composites, ou encore de feuilles de masquage pour écrans de télévision. De telles feuilles peuvent être réalisées en matériaux métalliques très divers, allant des métaux tels que le fer ou le nickel, à des alliages comme l'invar ou même à des superalliages.

Une méthode classique de fabrication d'une telle feuille perforée, comporte principalement deux étapes successives. En premier lieu, on produit une feuille mince, par exemple par laminage. Ensuite, on réalise les perforations requises par une technique d'usinage bien connue, telle que le poinçonnage, l'électro-érosion ou la gravure photochimique. Cette méthode est longue et coûteuse, d'une part en raison de la nécessité d'une opération d'usinage et d'autre part parce que l'usinage entraîne une perte de matière pouvant présenter une valeur importante.

Il existe également une autre méthode permettant de fabriquer une telle feuille métallique mince en une seule opération. Cette méthode consiste à former des îlots électriquement isolants sur une cathode, par la technique du masquage au moyen d'une résine photosensible, puis à déposer le métal par voie électrique sur la cathode ainsi préparée. Les îlots de résine n'étant pas réceptifs au dépôt électrique, on produit ainsi une feuille métallique perforée, que l'on détache alors de la cathode. En service, on a cependant constaté que cette méthode conduisait rapidement à des problèmes de dégradation de la cathode et par conséquent aussi de la qualité des feuilles minces perforées. En effet, la surface de contact entre les îlots de résine et la feuille métallique est le siège de phénomènes d'usure relativement sévères; selon les cas, ceux-ci peuvent provoquer soit la détérioration ou même le décollement des îlots de résine, soit des défauts tels que des fissures ou des déchirures de la feuille métallique mince.

L'objet de la présente invention est de remédier à ces inconvénients, en proposant un dispositif de fabrication d'une feuille métallique perforée de faible épaisseur, comportant une cathode particulière qui présente une très longue durée de vie.

Conformément à la présente invention, un dispositif de fabrication par électrodéposition d'une feuille métallique perforée de faible épaisseur, qui comporte une cathode électriquement conductrice ayant une surface active qui présente au moins un îlot non réceptif au dépôt, est caractérisé en ce que ledit îlot non réceptif au dépôt est noyé dans la cathode et en ce qu'il présente une face extérieure située à fleur de ladite surface active de la cathode.

Par surface active de la cathode, il faut entendre ici la surface sur laquelle la feuille métallique mince se forme par électrodéposition. Cette surface active peut être plane notamment dans le cas où la cathode est constituée par une bande sans fin; elle peut également être courbe, et en particulière cylindrique dans le cas d'une cathode en forme de tambour rotatif.

Par "matériau non réceptif au dépôt", on entend ici un matériau qui, dans les conditions de l'électrodéposition, ne se couvre pas d'un dépôt métallique. Il s'agit non seulement des matériaux isolants classiques, tels que les résines époxydes ou les résines phénoliques, mais aussi de matériaux qui se couvrent d'un dépôt électriquement isolant, par exemple d'une couche d'oxyde, ou qui donnent lieu à un dégagement gazeux, comme l'hydrogène, s'opposant à l'électrodéposition. Ce dernier cas vise notamment les îlots en métaux ou en carbures métalliques déposés par projection au moyen d'une torche à plasma. Ces matériaux englobent également les matériaux céramiques, tels que l'alumine ou la zircone.

Ces matériaux peuvent être déposés par toute méthode connue en soi, notamment en ce qui concerne les matériaux céramiques, par projection au plasma, par explosion, par CVD ou PVD ou encore par dépôt de poudre suivi de cuisson.

Suivant une variante particulière de l'invention, le dispositif comporte une cathode conductrice massive dont la surface active est pourvue d'au moins un creux s'ouvrant dans ladite surface active et ledit creux est rempli d'un matériau non réceptif au dépôt qui présente une face extérieure située à fleur de ladite surface active.

Suivant une autre variante de l'invention, le dispositif comporte une cathode composée d'une pièce de base présentant au moins une face et d'une couche électriquement conductrice déposée sur ladite face, ladite couche électriquement conductrice présentant une surface lisse, dite surface active, située à l'opposé de ladite face, et dans laquelle s'ouvre au moins un creux qui s'étend en profondeur sur au moins une partie de l'épaisseur de ladite couche électriquement conductrice, ledit creux étant rempli d'un matériau non réceptif au dépôt qui présente une face extérieure située à fleur de ladite surface active.

Suivant une autre caractéristique de cette variante, ladite couche électriquement conductrice est constituée d'au moins un métal choisi parmi le tungstène (W), le palladium (Pd) et le platine (Pt).

Sous un autre de ses aspects, la présente invention porte sur un procédé pour réaliser le dispositif qui vient d'être décrit.

D'une manière générale, le procédé de l'invention est caractérisé en ce que l'on noie au moins un îlot non réceptif au dépôt dans la cathode de telle façon que ledit îlot présente une face extérieure située à fleur de la surface active de la cathode.

De préférence, il est prévu une pluralité d'îlots non réceptifs au dépôt, répartis suivant la répartition désirée des perforations dans la feuille métallique de faible épaisseur.

Une première modalité de mise en oeuvre de ce procédé, qui correspond à la première variante précitée de la cathode conforme à l'invention, consiste à former au moins un creux dans la surface active de la cathode, à remplir ledit creux au moyen d'un matériau non réceptif au dépôt et à niveler ledit matériau non réceptif au dépôt de telle manière que sa face extérieure soit située à fleur de ladite surface active de la cathode.

Les creux peuvent être formés par toute méthode connue en soi; on citera en particulier l'usinage classique, notamment par perçage ou fraisage, la photogravure, ou encore la gravure par faisceau laser ou par faisceau d'électrons. Ces deux dernières méthodes sont particulièrement intéressantes, parce qu'elles peuvent être pilotées aisément et parce qu'elles peuvent aussi s'appliquer à des matériaux durs ou à des matériaux réfractaires.

Selon l'invention, la profondeur desdits creux est inférieure à 1 mm, et de préférence comprise entre 0,01 mm et 0,5 mm. Elle dépend notamment du type de matériau non réceptif au dépôt utilisé pour remplir lesdits creux. La nature et les propriétés de ce matériau non réceptif au dépôt peuvent également influencer le profil desdits creux.

Le positionnement de la face extérieure dudit matériau non réceptif au dépôt à fleur de la surface active de la cathode peut être réalisé directement lors du remplissage desdits creux, en veillant à ne pas déborder de ceux-ci avec le matériau non réceptif au dépôt.

Il s'est cependant avéré intéressant, conformément à la présente invention, de remplir lesdits creux avec un certain excédent de matériau non réceptif au dépôt et de rectifier ensuite la surface de la cathode de façon à enlever l'excédent de matériau non réceptif au dépôt et à mettre la face extérieure de celui-ci exactement à fleur de la surface active de la cathode.

Suivant une autre modalité de mise en oeuvre, qui correspond à la seconde variante précitée de la cathode conforme à l'invention, on dépose une couche substantiellement continue de matériau non réceptif au dépôt sur la face d'une pièce de base de la cathode, on élimine sélectivement ledit matériau non réceptif au dépôt de manière à laisser subsister au moins un îlot de matériau non réceptif au dépôt sur ladite face, et on dépose sélectivement une couche de matériau électriquement conducteur sur les régions de ladite face qui ne comportent plus de matériau non réceptif au dépôt.

Le matériau non réceptif au dépôt peut être éliminé par toute méthode connue en soi, par exemple par usinage classique ou au moyen d'un faisceau laser ou d'un faisceau d'électrons.

Le matériau électriquement conducteur peut être déposé par toute méthode usuelle, mais de préférence par électrodéposition. A cet effet, on utilise de préférence un métal choisi parmi le tungstène, le palladium, le platine ou leurs alliages.

L'épaisseur de la couche de matériau électriquement conducteur est au moins proche de, et de préférence sensiblement égale à celle dudit îlot de matériau non réceptif au dépôt.

De préférence, il est prévu une pluralité d'îlots de matériau non réceptif au dépôt, répartis suivant la répartition désirée des perforations de la feuille métallique de faible épaisseur.

Encore un autre aspect de la présente invention porte sur un procédé d'utilisation du dispositif décrit plus haut pour fabriquer une feuille métallique perforée de faible épaisseur.

Suivant cet aspect de l'invention, un procédé de fabrication d'une feuille métallique perforée de faible épaisseur consiste à former une couche dudit métal par électrodéposition sur la surface active d'une cathode comportant au moins un îlot de matériau non réceptif au dépôt dont la face extérieure est située à fleur de ladite surface active et à détacher ladite couche de métal de la surface active de la cathode sous la forme d'une feuille métallique présentant une perforation à l'endroit dudit îlot de matériau non réceptif au dépôt.

Comme on l'a déjà indiqué plus haut, il est de préférence prévu une pluralité de tels îlots de matériau non réceptif au dépôt sur ladite surface active de la cathode; ces îlots présentent une répartition et éventuellement une forme correspondant à la répartition et à la forme des perforations que l'on désire former dans ladite feuille métallique de faible épaisseur.

D'autres particularités et avantages de la présente invention apparaîtront à la lecture de la description qui va suivre, laquelle est illustrée par les dessins annexés dans lesquels la

Fig. 1 montre une vue en plan d'une feuille métallique perforée; la

Fig. 2 illustre le procédé habituellement utilisé pour réaliser la feuille métallique perforée de la Fig. 1; la

Fig. 3 comporte une série de vues en coupe montrant les étapes de fabrication d'une cathode et d'une feuille métallique perforée suivant la première variante de la présente invention; et la

Fig. 4 comporte une série de vues en coupe montrant les étapes de fabrication d'une cathode et d'une feuille métallique perforée suivant la deuxième variante de la présente invention.

Ces diverses figures constituent bien entendu des représentations schématiques, dans lesquelles on n'a indiqué que les éléments nécessaires à la bonne compréhension de l'invention. Des éléments identiques ou analogues sont à cet effet désignés par les mêmes repères numériques dans toutes les figures.

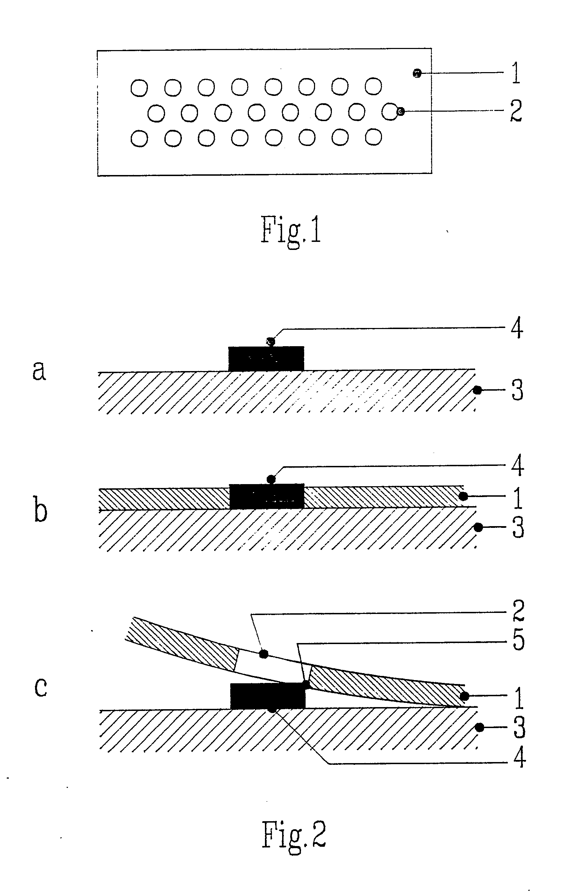

La Fig. 1 montre une vue en plan d'une feuille métallique 1 pourvue de perforations 2. Le nombre, la forme et la répartition des perforations représentées dans cette figure ne sont donnés qu'à titre de simple exemple.

Le procédé habituel de fabrication de la feuille métallique perforée 1 est illustré dans la Fig. 2. On utilise une cathode 3 dont la surface est garnie d'un certain nombre d'îlots 4 en matériau non réceptif au dépôt (vue a). On dépose sur la cathode 3, par électrodéposition, une couche métallique 1 dans laquelle les îlots 4 se trouvent emprisonnés (vue b). La feuille métallique 1 est détachée de la surface de la cathode 3 en se libérant des îlots 4. Pendant cette opération de séparation, des efforts de frottement importants naissent aux arêtes 5 avec pour conséquence une usure des îlots 4 et une détérioration des arêtes 5 des perforations 2 (vue c).

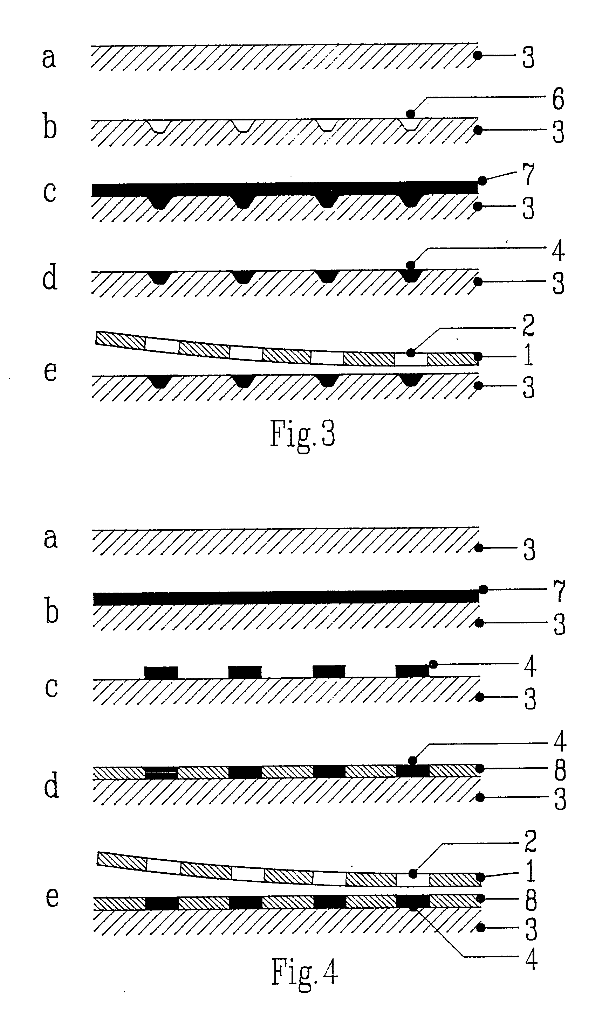

Les vues (a) à (e) de la Fig. 3 expliquent une première variante du procédé de l'invention pour produire non seulement une cathode améliorée mais aussi une feuille métallique perforée dont les perforations présentent des arêtes nettes. Dans la surface active de la cathode 3, on forme des creux 6 ayant la forme, le nombre et la répartition requises pour la feuille métallique à fabriquer. Sur la surface ainsi préparée, on dépose du matériau non réceptif au dépôt 7 de manière à remplir les creux 6, de préférence avec un excédent de matériau qui peut former une couche ininterrompue. On élimine ensuite cet excédent de matériau, par exemple par usinage, et on obtient la surface active de la cathode 3 dans laquelle sont noyés des îlots 4 de matériau non réceptif au dépôt (vue d). On dépose alors la couche métallique de l'épaisseur désirée sur la cathode ainsi préparée, et on détache cette couche sous la forme d'une feuille métallique 1 pourvue de perforations 2 disposées suivant les îlots de matériau non réceptif au dépôt 4.

D'une manière similaire, les vues (a) à (e) de la Fig. 4 exposent les opérations successives constituant la deuxième variante de la présente invention. En premier lieu, la cathode 3 est pourvue d'une couche substantiellement continue de matériau non réceptif au dépôt 7. Celle-ci est éliminée sélectivement par une méthode connue pour ne laisser subsister que des îlots 4 de ce matériau non réceptif au dépôt sur la surface de la cathode 3. On dépose ensuite, par électrodéposition, une couche de matériau électriquement conducteur 8 sur la cathode 3 ainsi préparée, et cette couche emprisonne les îlots 4. De préférence, la couche 8 a sensiblement la même épaisseur que les îlots 4. Enfin, on dépose la couche métallique 1 sur la couche conductrice 8, puis on la détache de cette couche 8 sous la forme de la feuille métallique 1 pourvue des perforations 2.

Enfin, un dernier aspect de l'invention porte sur une feuille métallique perforée, de faible épaisseur, obtenue par électrodéposition au moyen de l'une ou l'autre des variantes précitées de la cathode de l'invention. Comme on l'a déjà indiqué dans la description, l'épaisseur de cette feuille métallique perforée est inférieure à 500 μm. En outre, le nombre de perforations, leur forme et leur répartition dans la feuille dépendent généralement de l'application à laquelle la feuille est destinée.

La présente invention permet d'obtenir des feuilles métalliques perforées, de faible épaisseur, présentant des perforations nettes qui ne risquent pas de provoquer des fissures ou des déchirures de la feuille métallique. En outre, les îlots de matériau non réceptif au dépôt donnant naissance à ces perforations ne sont pas endommagés et présentent dès lors une durée de vie nettement accrue par rapport à la technique antérieure. Enfin, la deuxième variante décrite ci-dessus est particulièrement intéressante, puisqu'en cas de détérioration des îlots de matériau non réceptif au dépôt, il suffit de nettoyer la surface de la cathode et de reconstituer la couche métallique conductrice avec ses îlots isolants.

L'invention n'est évidemment pas limitée aux exemples de mise en oeuvre qui ont été décrits et illustrés plus haut. Elle s'étend en fait à toutes les modifications et variantes que tout homme de métier pourrait y apporter dans le cadre des revendications qui suivent.

**Revendications**

1. Dispositif de fabrication, par électrodéposition, d'une feuille métallique perforée de faible épaisseur, qui comporte une cathode électriquement conductrice ayant une surface active qui présente au moins un îlot non réceptif au dépôt, caractérisé en ce que ledit îlot non réceptif au dépôt (4) est noyé dans la cathode et en ce qu'il présente une face extérieure située à fleur de ladite surface active de la cathode.

2. Dispositif suivant la revendication 1, caractérisé en ce qu'il comporte une cathode conductrice massive (3) dont la surface active est pourvue d'au moins un creux (6) s'ouvrant dans ladite surface active et en ce que ledit creux (6) est rempli d'un matériau non réceptif au dépôt (7) qui présente une face extérieure située à fleur de ladite surface active.

3. Dispositif suivant la revendication 1, caractérisé en ce qu'il comporte une cathode composée d'une pièce de base (3) présentant au moins une face et d'une couche électriquement conductrice (8) déposée sur ladite face, ladite couche électriquement conductrice présentant une surface lisse, dite surface active, située à l'opposé de ladite face, et dans laquelle s'ouvre au moins un creux qui s'étend en profondeur sur au moins une partie de l'épaisseur de ladite couche électriquement conductrice, ledit creux étant rempli d'un matériau non réceptif au dépôt (4) qui présente une face extérieure située à fleur de ladite surface active.

4. Dispositif suivant l'une ou l'autre des revendications 1 à 3, caractérisé en ce que ledit îlot (4) non réceptif au dépôt est constitué soit d'un matériau électriquement isolant, soit d'un matériau qui s'oppose à la formation d'un dépôt métallique dans les conditions de l'électrodéposition.

5. Procédé pour réaliser un dispositif suivant l'une ou l'autre des revendications 1 à 4, caractérisé en ce que l'on noie au moins un îlot non réceptif au dépôt dans la cathode de telle façon que ledit îlot présente une face extérieure située à fleur de la surface active de la cathode.

6. Procédé suivant la revendication 5, caractérisé en ce que l'on forme au moins un creux dans la surface active de la cathode, en ce que l'on remplit ledit creux au moyen d'un matériau non réceptif au dépôt et en ce que l'on nivelle ledit matériau non réceptif au dépôt de telle manière que sa face extérieure soit située à fleur de ladite surface active de la cathode.

7. Procédé suivant la revendication 5, caractérisé en ce l'on dépose une couche substantiellement continue de matériau non réceptif au dépôt sur la face de la pièce de base de la cathode, en ce que l'on élimine sélectivement ledit matériau non réceptif au dépôt de manière à laisser subsister au moins un îlot de matériau non réceptif au dépôt sur ladite face, et en ce l'on dépose sélectivement une couche de matériau électriquement conducteur sur les régions de ladite face qui ne comportent plus de matériau non réceptif au dépôt.

8. Procédé suivant la revendication 7, caractérisé en ce que l'épaisseur de ladite couche de matériau électriquement conducteur est au moins proche de, et de préférence sensiblement égale à celle dudit îlot de matériau non réceptif au dépôt.

9. Procédé pour fabriquer une feuille métallique perforée de faible épaisseur au moyen d'un dispositif suivant l'une ou l'autre des revendications 1 à 4, caractérisé en ce que l'on forme une couche dudit métal par électrodéposition sur la surface active d'une cathode comportant au moins un îlot de matériau non réceptif au dépôt dont la face extérieure est située à fleur de ladite surface active et en ce que l'on détache ladite couche de métal de la surface active de la cathode sous la forme d'une feuille métallique présentant une perforation à l'endroit dudit îlot de matériau non réceptif au dépôt.

10. Feuille métallique perforée de faible épaisseur, obtenue par électrodéposition au moyen d'un dispositif suivant l'une ou l'autre des revendications 1 à 4.

Fig.1

Fig.2

Fig.3

Fig.4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | NL-A-8 003 127 (STORK) <br> * Totalité du brevet * <br> --- | 1,3,4,7 ,8,9,10 | C 25 D 1/08 |
| X | PATENT ABSTRACTS OF JAPAN, vol. 11, no. 259 (C-441)[2706], 21 août 1987; & JP-A-62 60 888 (USUI INT. CO.) 17-03-1987 <br> ----- | 1,2,4,5 ,10 | |

**DOMAINES TECHNIQUES RECHERCHES (Int. Cl.5)**

C 25 D

Le présent rapport a été établi pour toutes les revendications

| Lieu de la recherche | Date d'achèvement de la recherche | Examinateur |
|---|---|---|
| LA HAYE | 18-05-1990 | NGUYEN THE NGHIEP |